# EUROPÄISCHE PATENTSCHRIFT

(11) **EP 0 803 736 B1**
(45) Veröffentlichungstag und Bekanntmachung des Hinweises auf die Patenterteilung: **28.05.2008**
(21) Anmeldenummer: 97201103.5
(22) Anmeldetag: 14.04.1997
(51) Int. Cl.: G01R 33/34

(54) **MR-Gerät mit einer Zylinderspulenanordnung und einer Oberflächenspulenanordnung**
MR apparatus with cylindrical coil means and with surface coil means
Appareil de RM avec un dispositif de bobines cylindriques et avec un dispositif de bobines de surface

(30) Priorität: 25.04.1996 DE 19616464
(43) Veröffentlichungstag der Anmeldung: 29.10.1997
(73) Patentinhaber: Philips Intellectual Property & Standards GmbH, 20099 Hamburg (DE); Koninklijke Philips Electronics N.V., 5621 BA Eindhoven (NL)
(72) Erfinder: Leussler, Christoph, c/o Philips Patentverw.GmbH., 22335 Hamburg (DE)
(74) Vertreter: Volmer, Georg

(56) Entgegenhaltungen:
- EP-A- 0 338 624
- EP-A- 0 695 947
- WO-A-89/05115
- WO-A-93/03393

## Beschreibung

Die Erfindung betrifft ein MR-Gerät für eine MR-Untersuchung mit Mitteln zum Empfangen von MR-Signalen aus einem von einem stationären homogenen Magnetfeld und überlagerten Gradienten-Magnetfeldern durchsetzten Untersuchungsbereich nach Anregung durch ein hochfrequentes Magnetfeld mittels einer MR-Spulenanordnung, welche eine Zylinderspulenanordnung und eine Oberflächenspulenanordnung aufweist.
Ein derartiges Magnetresonanz (MR)-Gerät ist aus der EP-A 616 229 bekannt. Dort werden gleichzeitig MR-Signale aus mehreren Bereichen des Körpers eines Patienten mit Hilfe mehrerer Spulenanordnungen empfangen. Die Zylinderspulenanordnung ist dabei beispielsweise ein zur Untersuchung des Kopfes ausgestalteter Birdcage-Resonator, die Oberflächenspulenanordnung ist beispielsweise eine Quadraturspulenanordnung, die auf der Brust des Patienten angeordnet ist. Während einer Untersuchung können damit MR-Bilder vom Kopf- und vom Brustbereich eines Patienten erstellt werden.

EP 0 695 947 A1 offenbart ein MR-Gerät mit einer Oberflächenspulen-Anordnung mit vier Oberflächenspulen und einer Körperspulen-Anordnung, beispielsweise einer Spule vom Birdcage-Typ. Die vier Oberflächenspulen können auf einem flexiblen Träger angeordnet sein, der um den Patienten herumgewickelt wird, wobei sich die vier Oberflächenspulen in einem definierten Bereich überlappen, so dass sich eine gute Entkopplung zwischen diesen Oberflächenspulen ergibt. Zwischen der Oberflächenspulen-Anordnung einerseits und der Körperspulen-Anordnung andererseits ist jedoch eine Entkopplung nicht erreichbar.

Mit Zylinderspulenanordnung ist allgemein eine Spulenanordnung gemeint, die zylinderförmig ausgestaltet ist und bei einer MR-Untersuchung einen oder mehrere Körperteile des Patienten umschliesst. Im umschlossenen Bereich weist die Zylinderspulenanordnung eine im wesentlichen homogene Empfindlichkeit auf, wobei meist nur ein Kanal zum Empfang der von der Zylinderspulenanordnung gemessenen MR-Signale erforderlich ist. Mit Oberflächenspulenanordnung bzw. davon umfassten Oberflächenspulen sind Spulen gemeint, die auf oder in der Nähe der Oberfläche des Körpers eines Patienten angeordnet werden, den Körper oder Körperteile aber nicht umschliessen. Derartige Oberflächenspulen weisen ein lokal erhöhtes Signal/Rauschverhältnis auf, haben jedoch auch eine deutlich inhomogene

Empfindlichkeit. Meist erfordern eine oder zwei derartige Oberflächenspulen gemeinsam einen eigenen Empfangskanal.

Der vorliegenden Erfindung liegt die Aufgabe zugrunde, ein MR-Gerät der eingangs genannten Art weiter zu verbessern.

Diese Aufgabe wird erfindungsgemäß dadurch gelöst, dass sich die Zylinderspulenanordnung und die Oberflächenspulenanordnung in einem Überlappungsbereich überlappen und dass das MR-Gerät Mittel zur Variation der Größe des Überlappungsbereichs aufweist.

Es wurde festgestellt, dass eine weitgehende Entkopplung der beiden Spulenanordnungen voneinander dadurch erreicht werden kann, dass sich die beiden Spulenanordnungen überlappen. Weiterhin wurde festgestellt, dass die Größe des Überlappungsbereichs einen großen Einfluss auf die Stärke der Kopplung hat. Deswegen sind erfindungsgemäß. Mittel vorgesehen, mit denen die Größe des Überlappungsbereichs vor oder während der Untersuchung variiert werden kann. Vor der Untersuchung könnte dabei beispielsweise ein Phantomkörper (z.B. ein mit Wasser gefülltes Behältnis) im Untersuchungsbereich angeordnet und der Überlappungsbereich solange verändert werden, bis das beste Signal / Rauschverhältnis erzielt wird. Dies könnte auch zu Beginn der Untersuchung eines Patienten erfolgen, was den Vorteil hat, dass dessen Körperanatomie bei der Einstellung des besten Signal/Rauschverhältnisses unmittelbar Berücksichtigung findet.

Mit dem erfindungsgemäßen MR-Gerät ist es möglich, ein zusammenhängendes MR-Bild eines verhältnismäßig großen Bereichs zu erhalten, wobei nur eine geringe Anzahl von Empfangskanälen erforderlich ist, im Gegensatz zu einer Anordnung mit einer Vielzahl von einen gleich großen Bereich abdeckenden Oberflächenspulen, wofür wesentlich mehr Empfangskanäle erforderlich wären. Dabei ist auch eine ausreichende Homogenität und ein genügend großer Signal/Rauschabstand gewährleistet, da Kopplungen zwischen den Spulenanordnungen durch die Erfindung weitestgehend unterdrückt werden. Ein weiterer Vorteil der Erfindung liegt darin, dass sowohl für die Zylinderspulen- als auch für die Oberflächenspulenanordnung herkömmliche Spulenanordnungen verwendet werden können, wobei lediglich geringfügige konstruktive Veränderungen vorgenommen werden müssen.

In einer Weiterbildung der Erfindung ist vorgesehen, dass die Zylinderspulenanordnung mindestens einen Birdcage-Resonator, eine Sattelspulenanordnung, eine Solenoidspulenanordnung oder eine Loop-Array-Spulenanordnung aufweist. Ein Birdcage-Resonator ist aus der eingangs genannten EP-A 616 229 bekannt, eine aus mehreren induktiv gekoppelten Schleifen bestehende Loop-Array-Spulenanordnung ist aus der US-PS 50 03 265 bekannt. Eine Sattelspulenanordnung besteht beispielsweise aus zwei einzelnen sogenannten Sattelspulen, die als Schleifen ausgestaltet sind und auf gegenüberliegenden Seiten jeweils die Hälfte des Umfanges eines Körpers oder eines Körperteils überdecken. Eine Solenoidspulenanordnung ist eine in Form einer Spirale ausgebildete Spulenanordnung.

In einer weiteren Ausgestaltung der Erfindung ist vorgesehen, dass die Oberflächenspulenanordnung mindestens eine der Körperoberfläche eines Patienten zumindest bereichsweise angepasste Oberflächenspule aufweist. Derartige Oberflächenspulen weisen ein besonders gutes Signal/Rauschverhältnis in dem Körperbereich auf, den sie bedecken. Bei einer mehrere Oberflächenspulen umfassenden Oberflächenspulenanordnung sind benachbarte Oberflächenspulen ebenfalls zur Verminderung der gegenseitigen Kopplung überlappt. Auch dabei können Mittel zur Veränderung der Größe des Überlappungsbereichs vorgesehen sein.

Eine bevorzugte Weiterbildung der Erfindung sieht vor, dass die Zylinderspulenanordnung derart ausgestaltet ist, dass sie den Kopf eines Patienten in geringem Abstand umschließen kann, und dass die Oberflächenspulenanordnung derart ausgestaltet ist, dass sie dem Brust- und/oder Nackenbereich eines Patienten anpassbar ist. Damit können MR-Bilder, z.B. sagitale oder koronale Schnittbilder von der Kopfoberseite bis zum Herzen erstellt werden. Eine praktische Ausführung weist ein Sichtfeld (field-of-view) einer Länge von etwa 45 cm auf.

Eine weitere Ausgestaltung der Erfindung sieht vor, dass die Mittel zur Einstellung der Größe des Überlappungsbereichs eine Schieneneinrichtung umfassen, die eine Verschiebung der Oberflächenspulenanordnung gegenüber der Zylinderspulenanordnung ermöglicht. Dies ist eine konstruktiv einfache und billige Lösung, um die auch herkömmliche Spulenanordnungen auf einfache Weise erweitert werden können. Es sind jedoch auch andere Mittel als eine Schieneneinrichtung denkbar, die bei der Ausführung eines erfindungsgemäßen MR-Geräts zur Verschiebung der Oberflächenspulenanordnung gegenüber der Zylinderspulenanordnung vorgesehen werden können. Es kann weiterhin eine Verschiebesicherung vorgesehen sein, mit der eine Variation des Überlappungsbereichs verhindert wird, nachdem die optimale Größe des Überlappungsbereichs gefunden wurde. Dies können beispielsweise eine Feststellschraube oder eine mechanische Verriegelung sein.

Es ist weiterhin in einer Ausgestaltung der Erfindung vorgesehen, dass die Oberflächenspulenanordnung Oberflächenspulen aufweist, deren Größe veränderbar ist. Es wurde festgestellt, dass der Überlappungsbereich um so kleiner ausgeführt werden muss, je breiter die der Zylinderspulenanordnung benachbarte Seite einer Oberflächenspule ist. Im Umkehrschluss könnte also bei einem einmal fixierten Überlappungsbereich durch Variation der Größe, insbesondere der Breite eine Oberflächenspule eine Optimierung des Signal/Rauschverhältnisses erreicht werden. Denkbar wäre auch, sowohl die Größe des Überlappungsbereichs als auch die Größe der Oberflächenspule zu variieren. Durch Variation der Größe der Oberflächenspule könnte auch während bzw. unmittelbar vor der Untersuchung das field-of-view der Oberflächenspule an die Anforderungen an das gewünschte Bild oder die Körperanatomie des Patienten angepasst werden.

Die Erfindung wird nachfolgend anhand der Zeichnung erläutert. Es zeigen:
Fig.1 ein Blockschaltbild eines erfindungsgemäßen MR-Geräts,
Fig.2 eine Ausgestaltung eines erfindungsgemäßen MR-Geräts für den Kopf- und Brustbereich,
Fig.3 eine Draufsicht auf einen Teil des MR-Geräts gemäß Fig. 2 und
Fig.4 eine weitere Ausgestaltung eines erfindungsgemäßen MR-Geräts.

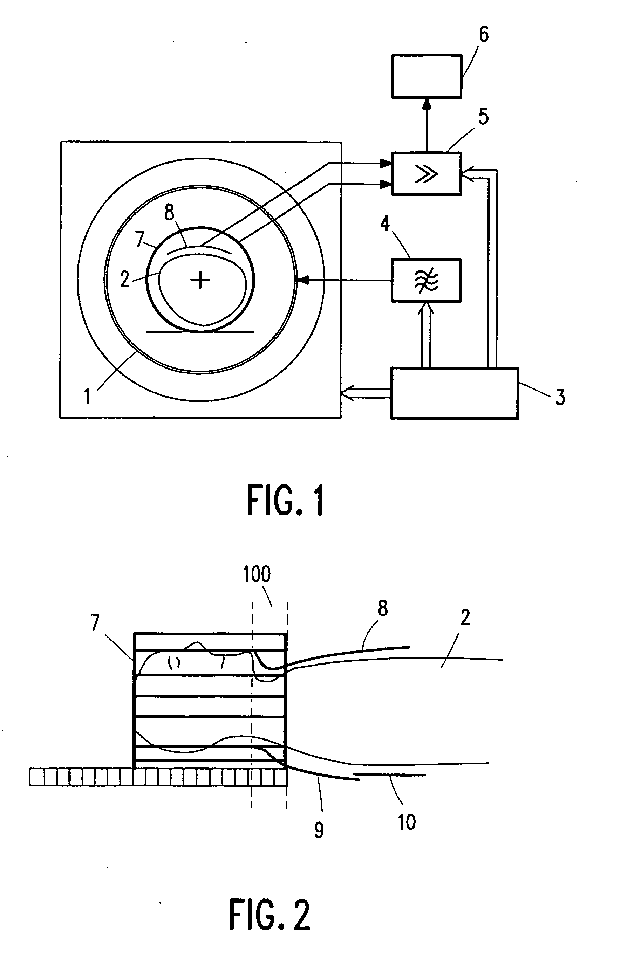

Das in Fig. 1 dargestellte MR-Gerät enthält eine Hochfrequenzspulenanordnung 1 mit hohlzylindrischem Querschnitt, die in ihrem Innern ein zur Zeichenebene senkrechtes, hochfrequentes Magnetfeld erzeugt, das den Untersuchungsbereich durchsetzt, in dem sich ein Patient 2 befindet, dessen Körperlängsachse senkrecht zur Zeichenebene verläuft. Das MR-Gerät besitzt weiter einen nicht näher dargestellten Hauptfeldmagneten, der ein senkrecht zur Zeichenebene verlaufendes, stationäres homogenes Magnetfeld erzeugt. Weiterhin weist das MR-Gerät ebenfalls nicht näher dargestellte Gradientenspulen auf, die ebenfalls senkrecht zur Zeichenebene verlaufende Magnetfelder erzeugen, jedoch mit einem Gradienten in jeweils einer von drei zueinander senkrecht stehenden Richtungen. Eine Steuereinheit 3 steuert die Erzeugung der zuvor beschriebenen Felder. Insbesondere steuert sie einen Oszillator 4, der mit der Hochfrequenzspulenanordnung 1 verbunden ist, durch die im Sendebetrieb die Hochfrequenzanregung erfolgt. Weiterhin steuert die Steuereinheit 3 einen Hochfrequenzempfänger 5, der mit verschiedenen Empfangsspulen verbunden ist und die empfangenen Kernresonanzsignale verstärkt, demoduliert und digitalisiert. Die Verarbeitung der Signale erfolgt anschließend in der Verarbeitungseinheit 6. Als Empfangsspulen sind hier eine Zylinderspulenanordnung 7, die einen Teil des Körpers des Patienten 2 zylinderförmig umschließt, sowie eine Oberflächenspulenanordnung 8, die einen Teil der Körperoberfläche des Patienten bedeckt, gezeigt.

In Fig. 2 ist eine Ausgestaltung der Erfindung zur Erstellung von zusammenhängenden MR-Bildern aus dem Kopf- und Brustbereich eines Patienten 2 dargestellt. Die Zylinderspulenanordnung ist hier ein bekannter Birdcage-Resonator 7, der den gesamten Kopf eines Patienten 2 bis zum Hals umschließt. Mit einem derartigen Birdcage-Resonator 7 können MR-Bilder des Kopfes erstellt werden, wobei im Empfänger ein einziger Empfangskanal vorgesehen werden muß. Im Brustbereich des Patienten 2 ist auf der Körperoberfläche eine erste Oberflächenspule 8 angeordnet, die der Körperoberfläche insbesondere im Halsbereich angepaßt ist. Die Oberflächenspule 8 und der Birdcage-Resonator 7 überlappen sich in einem Überlappungsbereich 100, d.h., die Oberflächenspule 8 ragt teilweise in den von dem Birdcage 7 umschlossenen Raum hinein. Im Nacken- und Schulterbereich des Patienten 2 ist eine weitere der Körperoberfläche angepaßte Oberflächenspule 9 angeordnet. Diese ist ebenfalls dem Birdcage-Resonator 7 überlappt, d.h. sie ragt ebenfalls in dessen Innenraum teilweise hinein. Im Rückenbereich des Patienten 2 ist eine weitere Oberflächenspule 10 angeordnet, die der Oberflächenspule 9 teilweise überlappt ist. Insgesamt werden für das gezeigte MR-Gerät vier Empfangskanäle benötigt.

Die Oberflächenspulen 8,9,10 sind bei der gezeigten Ausführungsform jeweils aus einer einzelnen Drahtschleife aufgebaut. Der Anteil der Fläche der Oberflächenspulen 8 und 9, der sich mit dem Birdcage-Resonator 7 überlappt, beträgt in der Praxis etwa 10 bis 20% der Gesamtfläche der Oberflächenspulen 8,9. Die Breite des Überlappungsbreichs liegt im Bereich von einigen cm. Die Größe des Überlappungsbereichs hängt jedoch auch von der Art, der Gestaltung und der Größe der Spulen sowie von der Anatomie des Patienten ab.

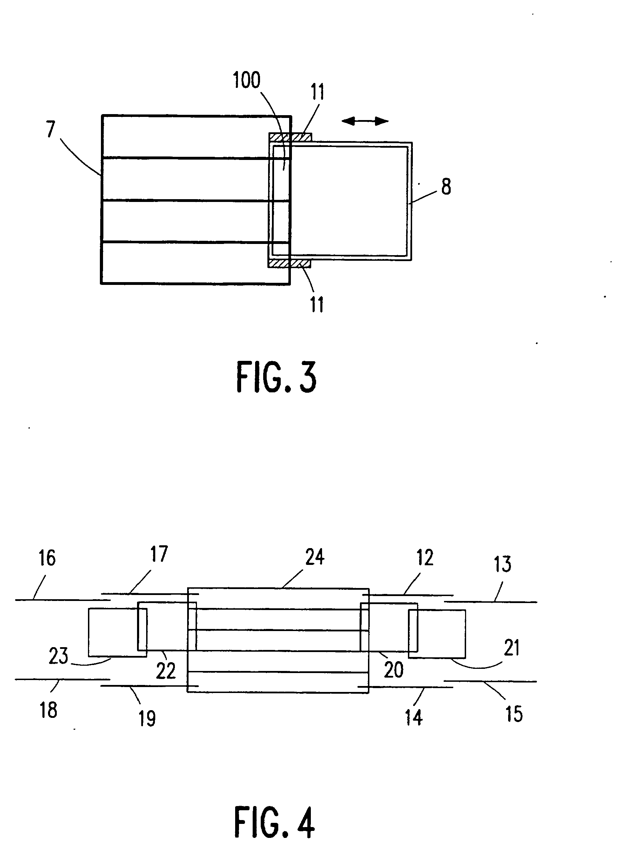

Eine Draufsicht auf einen Teil der in Fig. 2 gezeigten Ausführungsform ist in Fig. 3 dargestellt. Zu erkennen ist der Überlappungsbereich 100 des Birdcage-Resonators 7 und der Oberflächenspule 8. Mit 11 ist eine auf beiden Seiten der Oberflächenspule 8 angebrachte Schieneneinrichtung bezeichnet, die in einer am Birdcage-Resonator 7 angebrachten (nicht gezeigten) Schiene gleitet. Dadurch kann die Oberflächenspule 8 in der mit dem Doppelpfeil angedeuteten Richtung gegenüber dem Birdcage-Resonator 7 verschoben werden, wodurch sich die Größe des Überlappungsbereichs 100 verändert.

In Fig. 4 ist eine alternative Ausführungsform eines erfindungsgemäßen MR-Geräts dargestellt. Diese umfaßt einen Birdcage-Resonator 24 sowie eine Vielzahl von Oberflächenspulen 12 bis 23. Die dem Birdcage-Resonator 24 benachbarten Oberflächenspulen 12,14,17,19,20,22 überlappen sich hier ebenfalls mit dem Birdcage-Resonator 24. Die weiteren Oberflächenspulen 13,15,16,18,21,23 überlappen sich jeweils mit der benachbarten Oberflächenspule. Die gezeigte Ausführungsform ist beispielsweise zur Erstellung von MR-Bildern eines gesamten Beins eines Patienten geeignet. Der Birdcage-Resonator 24 ist dabei beispielsweise um das Knie angeordnet, die Oberflächenspulen sind über den Ober- bzw. Unterschenkel verteilt. Zur Reduzierung der Zahl der Empfangskanäle können die empfangenen Signale von jeweils zwei Oberflächenspulen auch nach entsprechender Verarbeitung mit einer Kombinationsschaltung auf einem Kanal empfangen und verarbeitet werden, so daß für diese Anordnung sieben Empfangskanäle erforderlich sind.

Ausgehend von der in Fig. 4 gezeigten Ausführungsform sind beliebige andere Ausführungsformen denkbar. Beispielsweise kann bei der in Fig. 4 gezeigten Ausführungsform im Endbereich ein weiterer Birdcage-Resonator oder eine Sattelspulenanordnung vorgesehen sein, die den Fuß des Patienten umschließt. Es sind auch zwei oder mehr Zylinderspulenanordnungen, die sich gegenseitig teilweise überlappen, denkbar.

Als Oberflächenspulen können neben den gezeigten rechteckigen Schleifen auch elliptische oder kreisrunde Schleifen, Quadraturspulen oder Butterflyspulen verwendet werden. Die Oberflächenspulenanordnung kann auch aus einer Kombination mehrerer verschiedener Oberflächenspulen bestehen, wobei auch mehrere Oberflächenspulen, beispielsweise eine Schleife und eine Butterflyspule übereinander angeordnet sind und in etwa den gleichen Bereich der Körperoberfläche überdecken. Auch die Ausgestaltung der Zylinderspulenanordnung kann von den gezeigten Ausführungsformen abweichen. Der Birdcage kann beispielsweise ebenfalls einen elliptischen Querschnitt haben und/oder eine leitende Endfläche und/oder Schulteröffnungen aufweisen.

Eine noch zusätzliche weitere Entkopplung zwischen der Oberflächenspulen- und der Zylinderspulenanordnung kann durch ein kapazitives Netzwerk zwischen den beiden Spulenanordnungen erfolgen, falls eine ausreichende Verbesserung der Entkopplung beispielsweise aus konstruktiven Gründen durch Veränderung der Größe des Überlappungsbereichs nicht möglich ist.

## Patentansprüche

1. MR-Gerät für eine MR-Untersuchung mit Mitteln zum Empfangen von MR-Signalen aus einem von einem stationären homogenen Magnetfeld und überlagerten Gradienten-Magnetfeldern durchsetzten Untersuchungsbereich nach Anregung durch ein hochfrequentes Magnetfeld mittels einer MR-Spulenanordnung, welche eine Zylinderspulenanordnung (7) und eine Oberflächenspulenanordnung (8) aufweist,
**dadurch gekennzeichnet, dass** sich die Zylinderspulenanordnung (7) und die Oberflächenspulenanordnung (8) in einem Überlappungsbereich (100) überlappen und dass das MR-Gerät Mittel (11) zur Variation der Größe des Überlappungsbereichs (100) aufweist.

2. MR-Gerät nach Anspruch 1,
**dadurch gekennzeichnet, dass** die Zylinderspulenanordnung mindestens einen Birdcage-Resonator (7), eine Sattelspulenanordnung, eine Solenoidspulenanordnung oder eine Loop-Array-Anordnung aufweist.

3. MR-Gerät nach Anspruch 1 oder 2,
**dadurch gekennzeichnet, dass** die Oberflächenspulenanordnung mindestens eine der Körperoberfläche eines Patienten (2) zumindest bereichsweise angepasste Oberflächenspule (8, 9, 10) aufweist.

4. MR-Gerät nach einem der vorhergehenden Ansprüche,
**dadurch gekennzeichnet, dass** die Zylinderspulenanordnung (7) derart ausgestaltet ist, dass sie den Kopf eines Patienten (2) in geringem Abstand umschließen kann, und dass die Oberflächenspulenanordnung (8, 9, 10) derart ausgestaltet ist, dass sie dem Brust- und/oder Nackenbereich eines Patienten (2) anpassbar ist.

5. MR-Gerät nach einem der vorhergehenden Ansprüche,
**dadurch gekennzeichnet, dass** die Mittel zur Einstellung der Größe des Überlappungsbereichs (100) eine Schieneneinrichtung (11) umfassen, die eine Verschiebung der Oberflächenspulenanordnung (8, 9) gegenüber der Zylinderspulenanordnung (7) ermöglicht.

6. MR-Gerät nach einem der vorhergehenden Ansprüche,
**dadurch gekennzeichnet, dass** die Oberflächenspulenanordnung Oberflächenspulen (8, 9, 10) aufweist, deren Größe veränderbar ist.

7. MR-Spulenanordnung, umfassend eine Zylinderspulenanordnung (7) und eine Oberflächenspulenanordnung (8),
**dadurch gekennzeichnet, dass** sich die Zylinderspulenanordnung (7) und die Oberflächenspulenanordnung (8) in einem Überlappungsbereich (100) überlappen und dass die MR-Spulenanordnung Mittel (11) zur Variation der Größe des Überlappungsbereichs (100) aufweist.

## Claims

1. An MR apparatus for an MR examination comprising means for the reception of MR signals from an examination zone exposed to a steady, uniform magnetic field and superposed gradient magnetic fields, after excitation by an RF magnetic field, using an MR coil system which includes a cylindrical coil system (7) and a surface coil system (8), **characterized in that** the cylindrical coil system (7) and the surface coil system (8) overlap in a region of overlap (100) and **in that** the MR apparatus includes means (11) for adjusting the size of the region of overlap (100).

2. An MR apparatus as claimed in claim 1, **characterized in that** the cylindrical coil system includes at least a bird-cage resonator (7), a saddle coil system, a solenoid coil system or a loop-array coil system.

3. An MR apparatus as claimed in claim 1 or 2, **characterized in that** the surface coil system includes at least one surface coil (8, 9, 10) which is adapted at least locally to the body surface of a patient (2).

4. An MR apparatus as claimed in any one of the preceding claims, **characterized in that** the cylindrical coil system (7) is constructed so that it can enclose the head of a patient (2) with a small clearance, the surface coil system (8, 9, 10) being constructed so that it can be adapted to the chest and/or neck regions of a patient (2).

5. An MR apparatus as claimed in any one of the preceding claims, **characterized in that** the means for adjusting the size of the region of overlap (100) include a rail device (11) which enables displacement of the surface coil system (8, 9) relative to the cylindrical coil system (7).

6. An MR apparatus as claimed in any one of the preceding claims, **characterized in that** the dimensions of the surface coils (8, 9, 10) included in the surface coil system can be varied.

7. An MR coil system which includes a cylindrical coil system (7) and a surface coil system (8), **characterized in that** the cylindrical coil system (7) and the surface coil system (8) overlap in a region of overlap (100), and **in that** the MR coil system comprises means (11) for adjusting the size of the region of overlap (100).

## Revendications

1. Appareil de RM pour un examen par RM comportant des moyens pour recevoir des signaux de RM provenant d'une plage d'examen traversée par un champ magnétique homogène stationnaire et par des champs magnétiques à gradient superposés, après excitation par un champ magnétique à haute fréquence au moyen d'un dispositif de bobines de RM, qui comprend un dispositif de bobines cylindriques (7) et un dispositif de bobines de surface (8), **caractérisé en ce que** le dispositif de bobines cylindriques (7) et le dispositif de bobines de surface (8) se recouvrent dans une zone de recouvrement (100) et **en ce que** l'appareil de RM comporte des moyens (11) pour faire varier la grandeur de la zone de recouvrement (100).

2. Appareil de RM selon la revendication 1, **caractérisé en ce que** le dispositif de bobines cylindriques comprend au moins un résonateur à cage d'oiseau (7), un dispositif de bobines en sellette, un dispositif de bobines à solénoïde ou un dispositif à réseau en boucle.

3. Appareil de RM selon la revendication 1 ou 2, **caractérisé en ce que** le dispositif de bobines de surface comprend au moins une bobine de surface (8, 9, 10) adaptée au moins localement à la surface du corps d'un patient (2).

4. Appareil de RM selon l'une quelconque des revendications précédentes, **caractérisé en ce que** le dispositif de bobines cylindriques (7) est configuré de telle manière qu'il puisse entourer à faible distance la tête d'un patient (2), et **en ce que** le dispositif de bobines de surface (8) est configuré de telle manière qu'il puisse être adapté à la région du thorax et/ou de la nuque d'un patient (2).

5. Appareil de RM selon l'une quelconque des revendications précédentes, **caractérisé en ce que** les moyens pour régler la grandeur de la zone de recouvrement (100) comprennent un dispositif sur rails (11), qui permet un déplacement du dispositif de bobines de surface (8, 9) par rapport au dispositif de bobines cylindriques (7).

6. Appareil de RM selon l'une quelconque des revendications précédentes, **caractérisé en ce que** le dispositif de bobines de surface comprend des bobines de surface (8, 9, 10), dont la grandeur est variable.

7. Dispositif de bobines de RM, comprenant un dispositif de bobines cylindriques (7) et un dispositif de bobines de surface (8), **caractérisé en ce que** le dispositif de bobines cylindriques (7) et le dispositif de bobines de surface (8) se recouvrent dans une zone de recouvrement (100) et **en ce que** le dispositif de bobines de RM comporte des moyens (11) pour faire varier la grandeur de la zone de recouvrement (100).
